Europäisches Patentamt

European Patent Office

Office européen des brevets

(19)

(11) Publication number: **0 012 019**
**B1**

## EUROPEAN PATENT SPECIFICATION

(12)

(45) Date of publication of patent specification: **12.10.83**

(21) Application number: **79302729.3**

(22) Date of filing: **29.11.79**

(51) Int. Cl.³: **H 01 L 23/48,**
**H 01 L 21/48,**
**H 01 L 23/04, H 01 L 25/04**

(54) An electrode for a semiconductor device and method of making such an electrode.

(30) Priority: **01.12.78 JP 149287/78**

(43) Date of publication of application:
**11.06.80 Bulletin 80/12**

(45) Publication of the grant of the patent:
**12.10.83 Bulletin 83/41**

(84) Designated Contracting States:
**DE FR GB NL**

(56) References cited:
**DE - A - 2 824 250**
**FR - A - 1 213 484**
**FR - A - 2 387 498**
**US - A - 3 969 754**

(73) Proprietor: **Hitachi, Ltd.**
**5-1, Marunouchi 1-chome**
**Chiyoda-ku Tokyo 100 (JP)**

(72) Inventor: **Tsuruoka, Masao**
**6-4 Nishinarusawacho-1-chome**
**Hitachi-shi (JP)**
Inventor: **Morita, Keiichi**
**14-5 Osecho-4-chome**
**Hitachi-shi (JP)**
Inventor: **Kuniya, Keiichi**
**24-10 Nishinarusawacho-1-chome**
**Hitachi-shi (JP)**

(74) Representative: **Paget, Hugh Charles Edward et al,**
**MEWBURN ELLIS & CO. 2/3 Cursitor Street**
**London EC4A 1BQ (GB)**

Courier Press, Leamington Spa, England.

# An electrode for a semiconductor device and method of making such an electrode

This invention relates to a semiconductor device comprising a semiconductor substrate at least one electrode bonded to a major surface of said substrate and a body of synthetic resin material covering at least one side surface of said substrate and at least one side surface of said electrode. The invention also relates to a method of making such a device.

In semiconductor devices, a semiconductor element is placed in a metal-ceramic composite casing or is covered by an insulating material such as synthetic resin or glass for protection from the adverse effects of the external atmosphere and external forces and for keeping a large distance along the surface between two electrodes and hence a high dielectric strength. Covering with synthetic resin is relatively simple and thus suitable for inexpensive semiconductor devices. A typical example of an inexpensive semiconductor device is one produced by soldering an S-shaped lead wire onto both sides of a small semiconductor element and covering the semiconductor element and the lead wires with synthetic resin (for instance, the MR 2500 series medium current silicon rectifiers (50 to 1000 volts, 25 amperes, diffused junction) available from Motorola Inc.).

It is known from US—A—3969754 and FR—A—2387498 to provide a semiconductor device in which the electrode has a coefficient of thermal expansion, in a direction parallel to the major surface of the substrate (i.e. the surface of the substrate to which the electrode is attached), which is approximately equal to the coefficient of thermal expansion of the substrate. In FR—A—2387498 this is achieved by providing an electrode of copper and carbon fibre in spiral form. In US—A—3969754 the method is similar except that metal fibres, e.g. tungsten are embedded in the copper. Such an arrangement avoids problems caused by differences between the thermal expansion of the electrode and the semiconductor substrate.

However, resin-mould packaged semiconductor devices of large current capacity, for example, about 400A at 1000V, have not yet been produced. One reason for this is that no arrangement has been produced whereby the electrode and the substrate are firmly bonded together and hermetically sealed. FR—A—2387498 suggests the use of glass to coat the sides of the device but this is not practicable as applied to large devices because of the fragility of the glass and the difficulty in providing a glass coating over a large area.

The present invention seeks to provide a semiconductor device, in which the electrode is firmly bonded to the semiconductor substrate. This is achieved in the present invention by surrounding the sides of the electrode and substrate with a body of synthetic resin which prevents lateral sliding between the electrode and the substrate, and exerts a clamping force thereon. The synthetic resin has approximately the same coefficient of thermal expansion as has the electrode in a direction perpendicular to the major surface of the substrate so that the clamping effect of the resin is not affected by sliding between the electrode and the resin caused by thermal expansion. Perfect matching of the coefficients of thermal expansion is generally not practicable, but the invention proposes that the matching of the coefficients is better than if the electric does not have anisotropic expansion characteristics.

This permits a device of large current capacity to be produced, and problems due to relative movement of the electrode and substrate, and the resin and the substrate are avoided. The present invention also enables the device to be protected at its sides by the resin moulding.

To produce a semiconductor device of the invention with such the desired thermal expansion characteristics, there is preferably employed a copper-carbon composite metal (or a composite body having carbon fibres embedded in substantially uniform distribution in a matrix of copper) having different thermal expansion coefficients in directions perpendicular to each other. In this way, good matching of the thermal expansion coefficients of the semiconductor substrate, the electrode materials and the synthetic resin may be achieved.

Embodiments of this invention will now be described by way of Example with reference to the accompanying drawings, in which:—

Fig. 1 is an explanatory exploded cross-sectional view of a semiconductor device embodying the invention;

Fig. 2 is a perspective view of the supporting electrode in Fig. 1;

Fig. 3 is a cross-sectional view of the resin-molded semiconductor device of Fig. 1 in the assembled state;

Fig. 4 is a sectional view of another device embodying the invention which is a button-type diode; and

Fig. 5 is a sectional view of yet another device embodying the invention, which is a composite device.

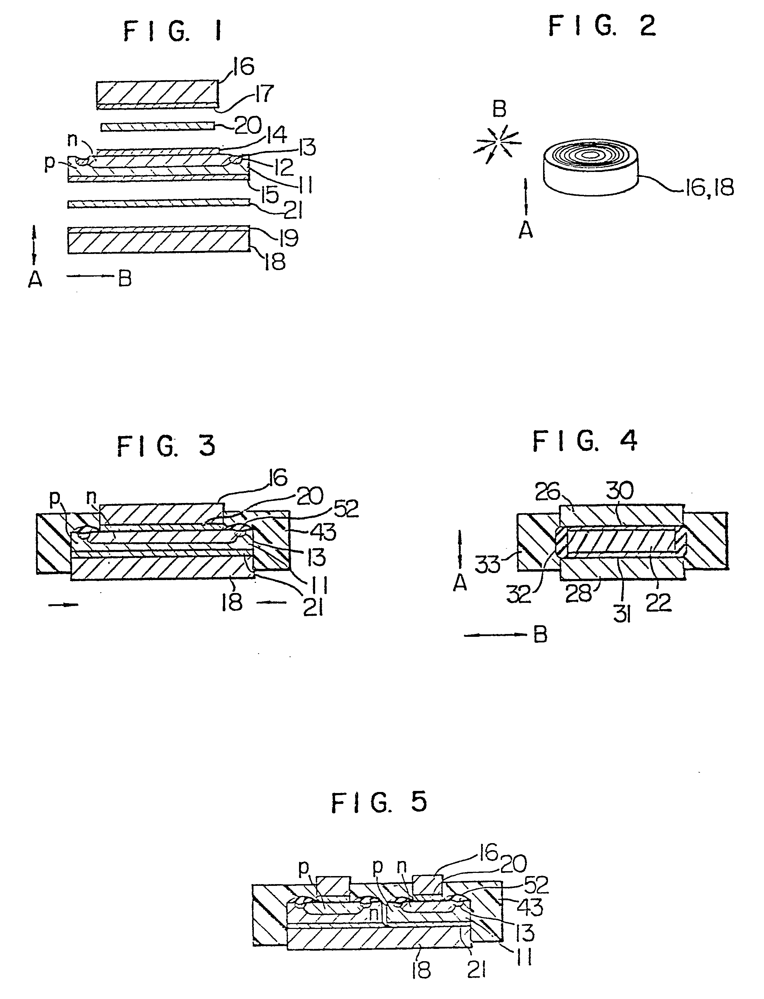

Fig. 1 is an exploded view showing the parts of the device before assembly of the semiconductor substrate and the supporting electrodes. A silicon substrate 11 has in its periphery a moat 12, the inner wall of which includes the end of the rectifying junction. A passivation glass material 13 is placed and sintered in the moat 12 and there are evaporated three-layer films 14 and 15 for ohmic contact each of which consists, for example, of a 0.1 $\mu$m thick chromium (Cr) layer,

a 0.6 $\mu$m thick nickel (Ni) layer and a 1.5 $\mu$m thick silver (Ag) layer. In addition, there are top and bottom supporting electrodes 16 and 18. Each of supporting electrodes 16, 18 is plated on at least one of its surfaces with silver to form a silver film 17, 19 of 10 $\mu$m thickness. Each of the electrodes 16, 18 itself is made of a material having the property of thermal expansion anisotropy as will be described below. For the purpose of this invention, the thermal expansion coefficient of the top and bottom electrodes 16 and 18 in the direction of arrow B, i.e. in any direction along the surface of the silicon substrate 11 (see Fig. 2) is preferably within the range $3.5 \times 10^{-6}/°C$ to $5 \times 10^{-6}/°C$, and the thermal expansion coefficient thereof in the direction of arrow A (see Fig. 2) is preferably in the range $15 \times 10^{-6}/°C$ to $30 \times 10^{-6}/°C$.

A copper carbon fiber composite metal as shown in Fig. 2 is suitable for the electrodes 16, 18 having this anisotropy. In this composite metal, carbon fibers each several microns in diameter are arranged in concentric circles or in a spiral having its centre at the core of the structure, the space between the fibers being filled with copper material. The volume ratio (by volume percent) of copper to carbon fibres is preferably kept in the range of 35 to 55% (carbon fibers): 65 to 45% (copper).

The thermal expansion coefficient $K_d$ of the supporting electrodes 16 and 18 in the direction of arrow B is given by the following expression, within the elastic limit:

$$K_d = \frac{K_f \cdot E_f \cdot V_f + K_m E_m (1 - V_f)}{E_f \cdot V_f + E_m (1 - V_f)}$$

where

$K_f$: coefficient of thermal expansion of fiber,
$K_m$: coefficient of thermal expansion of matrix,
$E_f$: Young's modulus of fiber,
$E_m$: Young's modulus of matrix,
$V_f$: volume ratio of fiber content.

If

$K_f = 3 \times 10^{-6}/°C$
$K_m = 16.5 \times 10^{-6}/°C$
$E_f = 23000$ kg/mm²
$E_m = 12000$ kg/mm²

and

$V_f = 0.4$

then

$K_d \doteqdot 5.5 \times 10^{-6}/°C$

which is approximately equal to the actual measured value.

The thermal expansion coefficient of the supporting electrodes 16 and 18 in the direction of arrow A is constant, $18 \times 10^{-6}/°C$ irrespective of the volume ratio of carbon fiber content.

To produce the supporting electrodes 16 and 18, a quantity of copper powder is first mixed into an aqueous solution of 3%-methyl cellulose to form a slurry. Then, copper plated carbon fibres are soaked into the copper powder in the slurry and subsequently the carbon fibers are arranged in a spiral form by a machine while a tension of 0.9 to 1.1 Kg is exerted on them to form a composite body. This composite body is then temporarily sintered at 350°C for one hour in a hydrogen ($H_2$) atmosphere, and is thereafter subjected to hot pressing in a pressed condition at 250 Kg/cm² and at a temperature of 980° to 1050°C for one hour in the $H_2$ atmosphere. The supporting electrode is then machined into the desired shape. The resulting electrode has a small thermal expansion coefficient in the directions parallel to its main surfaces (B direction) because of the concentrically or spirally restrained carbon fibers which have a small thermal expansion coefficient, but has a larger thermal expansion coefficient in its thickness direction (A direction) than that in the B direction because of there is slight restraint of the carbon fibers in this direction.

The supporting electrode thus produced is used to fabricate the semiconductor device of Fig. 3 in the following steps:—

The electrodes 16 and 18 are each plated on one of their surfaces with silver to form the layers 17 and 19, and are then subjected to stabilization by heat treatment at 250°C for 30 minutes in a vacuum. This stabilization step stabilizes the A- and B-direction thermal expansion coefficient the electrodes 16 and 18. Subsequently, solder layers 20 and 21 are formed on the plated surfaces 17 and 19 of the supporting electrodes 16 and 18 by evaporating lead (Pb) and then tin (Sn) onto the surfaces 17 and 19. These solder layers 20 and 21 are Pb5Sn and are 50 $\mu$m thick. The electrodes 16 and 18 with the solder layers 20 and 21 formed on them are then mounted on the silicon substrate 11 which has the ohmic contacts 14 and 15 on both surfaces. This mounting operation is performed at 295 to 305°C for 10 min., with a pressure of 0.2 kg/cm².

A silicon rubber 52 shown in Fig. 3 is placed on the sintered glass 13 in the moat 12 and is cured at 200°C for two hours. An epoxy resin 43 shown in Fig. 3 is applied and cured in the temperature range of 120°C to 150°C for 2 to 7 hours. The thermal expansion coefficient of this resin 43 is $25 \times 10^{-6}/°C$. The silicon rubber 52 serves as a buffer preventing the resin 43 from causing damage to the glass 13 by direct contact with the glass. Instead of sintering the glass 13 on the semiconductor, the silicon rubber 52, which covers the surface of the semiconductor 11 except where the electrodes 16 and 18 are attached, serves as a cushion to relieve the tensile stress caused by the difference between the thermal expansion coefficients of the substrate material 11 and the epoxy resin 43.

In this device, since the thermal expansion coefficients of the substrate 11 and the electrodes 16 and 18 are approximately equal in their main surface directions (the B-direction), no damage is caused to the substrate 11 and glass 13 by the different thermal expansion coefficients of the semiconductor 11 and the electrodes 16 and 18, nor is there thermal fatigue of the adhesive layers 20 and 21 between the semiconductor 11 and the electrodes 16 and 18. As for the thermal expansion coefficients of the electrodes 16 and 18 and the resin 43 in the B-direction, the sides of the electrodes 16 and 18 are always stretched in the radial direction by the synthetic resin 43, (i.e. there is a shrinkage-fit) which provides very good close adherence between the sides of the electrodes 16 and 18 and the synthetic resin 43.

As to the thermal expansion coefficients of the electrode members 16 and 18 and the synthetic resin 43 in the silicon-thickness direction (A-direction), since the thermal expansion coefficients of the two materials are approximately equal and there is little difference between the thermal expansions of the two materials, sliding between these two parts does not occur. Consequently there is satisfactory close adherence between the electrodes 16 and 18 and the protective resin 43 in cooperation with the steady adherence by the above-mentioned stretching. Thus, moisture is prevented from permeating into the semiconductor substrate 11 from outside through these boundaries between the electrodes 16 and 18 and resin 43.

Fig. 4 shows the invention applied to a so-called button-type diode. A silicon semiconductor element 22 is adhesively sandwiched by upper and lower electrodes 26 and 28 through solder layers 30 and 31, respectively. Silicon rubber 32 is attached to the end walls of the element 22, and epoxy resin 33 covers the element 22 over its sides between the upper and lower electrodes 26 and 28. In this embodiment, the thermal expansion coefficients of the electrodes 26 and 28 and the epoxy resin 33, and the anisotropic thermal expansion coefficients of the electrodes 26 and 28 in the A- and B-directions are all the same as in the device of Figs. 1 to 3. In addition, good close adhesion is between the electrodes 26 and 28 and the protective synthetic resin 33 is similarly achieved, thus preventing moisture from penetrating from outside into the element 22 through the boundaries between these parts.

While the two-terminal semiconductor devices are illustrated above, this invention is not limited to such devices, but can be naturally used for three-terminal devices such as thyristors or the like, without any limitation.

It will be understood from the foregoing description that this invention can be applied to a particularly large-size semiconductor which is covered with synthetic resin, because of the good functional matching among the thermal expansion coefficients of the semiconductor, electrodes and synthetic resin.

The thermal expansion coefficients of the electrodes used in the invention can be selected to be appropriate values within a certain range with respect to the surface direction and thickness direction thereof. This selection of thermal expansion coefficients may be performed by changing the proportions of the copper and carbon fibers in the electrodes, the shape and size of the fibers and the manner of mixing of the materials. It is preferable that the thermal expansion coefficient of the electrodes in the main surface direction is in the range $3.5 \times 10^{-6}/°C$ to $5 \times 10^{-6}/°C$, to match that of silicon, which is $3.5 \times 10^{-6}/°C$. Reduction of the thermal expansion coefficient of the electrodes to less than that of silicon would require an increase of the ratio of carbon fibers to copper with a consequent decrease of the thermal conductivity of the electrodes which is impractical.

The thermal expansion coefficient of the composite material of copper and fibres in its thickness direction is desirably selected so that the difference of thermal expansion between the electrodes and the resin material (which has a thermal expansion coefficient of $25 \times 10^{-6}/°C$) at the boundary between them is less than the width of a single carbon fiber the radius of which is usually about 5 $\mu$m. Hence it is desirable for the coefficient of thermal expansion of the electrodes in this direction to be within the range $20 \times 10^{-6}/°C$ to $30 \times 10^{-6}/°C$.

In Fig. 5, elements corresponding to those of Fig. 1 are identified by the same reference numerals. This semiconductor device differs from that of Fig. 3 in that a plurality of silicon semiconductor elements 11 are mounted on the lower supporting electrode 18 instead of the single element 11 shown in Fig. 3. That is to say, the device of Fig. 5 is a composite device. The electrodes 18, 16 are formed in the same manner as those of Fig. 3, though here of course there are two of each electrode 16 and 18.

As well as a plurality of silicon semiconductor elements 11 on the lower electrode 18, the device of the invention may incorporate circuit elements such as capacitors, and resistors.

## Claims

1. A semiconductor device comprising a semiconductor substrate (11, 22) and at least one electrode (16, 18, 26, 28) bonded to the major surface of the substrate;

the electrode (16, 18, 26, 28) being a composite body having fibres embedded in a metal matrix, the fibres being arranged substantially parallel to the major surface of the substrate (11, 22) such that the coefficient of thermal expansion of the electrode (16, 18, 26, 28) in directions parallel to said major surface of the substrate (11, 22) is equal or approximately equal to that of the substrate (11, 22) characterised in that: a body of synthetic resin material covers side surface portions of the substrate and the electrode so as to restrain relative lateral movement of the electrode and the substrate by applying a clamping force; and the coefficient of thermal expansion of the electrode (16, 18, 26, 28) in the direction perpendicular to said major surface of the substrate (11, 22) is equal or approximately equal to that of the synthetic resin material (33, 43) so that the clamping force is not affected by thermal expansion.

2. A device according to Claim 1 wherein, at least at a surface region of said electrode (which surface region is bonded to the substrate) the fibers are arranged in an annular configuration comprised of a plurality of concentric annuli or in a spiral configuration with a plurality of spirals having a common centre.

3. A device according to Claim 1 or Claim 2 wherein the fibers are carbon fibers and the metal matrix is copper, the percentage by volume of carbon fibers being in the range 35 to 55% and the percentage by volume of copper being in the range 45 to 65%.

4. A device according to any one of the preceding claims wherein the said coefficient of thermal expansion in directions parallel to said major surface is in the range $3.5 \times 10^{-6}/°C$ to $5 \times 10^{-6}/°C$ and the said coefficient of thermal expansion in the direction perpendicular to said major surface is in the range $15 \times 10^{-6}/°C$ to $30 \times 10^{-6}/°C$.

5. A device according to any one of the preceding claims, wherein said metal is copper.

6. A device according to any one of the preceding claims, wherein the substrate includes a moat, glass sintered in the moat, and silicon rubber on the glass.

7. A device according to any one of the preceding claims, wherein the fibres are copper-plated carbon and are arrayed to provide anisotropic thermal expansion characteristics.

8. A method of making a semiconductor device according to Claim 1 including the steps of

(a) forming a metal film (17, 19) on at least one surface of an electrode in the form of a composite body having fibres embedded in a metal matrix,

(b) then bonding said electrode by means of solder to the major surface of the semiconductor substrate (11, 22) characterised in that the side surface portions of said substrate and said electrode are covered with synthetic resin (33, 43) in a mould, the thermal expansion coefficient of the synthetic resin (33, 43) being equal or approximately equal to the thermal expansion coefficient of the electrode (16, 18, 26, 28) in the direction perpendicular to the major surface of the substrate (11, 22).

**Patentansprüche**

1. Halbleitervorrichtung mit einem Halbleitersubstrat (11, 22) und mindestens einer an die Hauptfläche des Substrats gebondeter Elektrode (16, 18, 26, 28);

wobei die Elektrode (16, 18, 26, 28) ein Verbundkörper mit in einer Metallmatrix eingebetteten Fasern ist, die Fasern im wesentlichen parallel zur Hauptfläche des Substrats (11, 22) angeordnet sind, so daß der Wärmeausdehnungskoeffizient der Elektrode (16, 18, 26, 28) in zur Hauptfläche des Substrats (11, 22) parallelen Richtungen gleich oder ungefähr gleich dem des Substrats (11, 22) ist, dadurch gekennzeichnet,

daß ein Körper aus Kunstharzmaterial Seitenflächenteile des Substrats und der Elektrode bedeckt, um seitliche Relativbewegungen zwischen der Elektrode und dem Substrat durch Aufbringen einer Klemmkraft zu hemmen; und

daß der Wärmeausdehnungskoeffizient der Elektrode (16, 18, 26, 28) in der zur Hauptfläche des Substrats (11, 22) senkrechten Richtung gleich oder ungefähr gleich ist dem des Kunstharzmaterials (33, 43), so daß die Klemmkraft durch die Wärmeausdehnung nicht beeinflußt wird.

2. Vorrichtung nach Anspruch 1, wobei die Fasern mindestens in einem (an das Substrat gebondeten) Oberflächenbereich der Elektrode in einer aus mehreren Konzentrischen Ringen aufgebauten ringförmigen Konfiguration oder in einer aus mehreren Spiralen mit einem gemeinsamen Zentrum aufgebauten spiralförmigen Konfiguration angeordnet sind.

3. Vorrichtung nach Anspruch 1 oder 2, wobei die Fasern Kohlenstoffasern und die Metallmatrix Kupfer ist, und wobei der Volumenanteil der Kohlenstoffasern im Bereich von 35 bis 55% und der Volumenanteil des Kupfers im Bereich von 45 bis 65% liegt.

4. Vorrichtung nach einem der vorhergehenden Ansprüche, wobei der Wärmeausdehnungskoeffizient in zur Hauptfläche parallelen Richtungen im Bereich von $3,5 \times 10^{-6}/°C$ bis $5 \times 10^{-6}/°C$ und der Wärmeausdehnungskoeffizient in der zur Hauptfläche senkrechten Richtung im Bereich von $15 \times 10^{-6}/°C$ bis $30 \times 10^{-6}/°C$ liegt.

5. Vorrichtung nach einem der vorhergehenden Ansprüche, wobei das Metall Kupfer ist.

6. Vorrichtung nach einem der vorhergehenden Ansprüche, wobei das Substrat eine Rinne, in der Rinne gesintertes Glas und Silikonkautschuk auf dem Glas aufweist.

7. Vorrichtung nach einem der vorhergehenden Ansprüche, wobei die Fasern aus Kupferbeschichtetem Kohlenstoff bestehen und zur Vermittlung anisotroper Wärmeausdehnungseigenschaften gruppiert sind.

8. Verfahren zur Herstellung einer Halbleitervorrichtung nach Anspruch 1, umfassend die Schritte des

(a) Ausbildens eines Metallfilms (17, 19) auf mindestens einer Oberfläche einer Elektrode in Form eines Verbundkörpers mit in einer Metallmatrix eingebetteten Fasern,

(b) des anschließenden Bondens der Elektrode mittels Lot an die Hauptfläche des Halbleitersubstrats (11, 22), dadurch gekennzeichnet, daß die Seitenflächenteile des Substrats und der Elektrode mit Kunstharz (33, 43) in einer Form bedeckt werden, wobei der Wärmeausdehnungskoeffizient des Kunstharzes (33, 43) gleich oder ungefähr gleich ist dem Wärmeausdehnungskoeffizient der Elektrode (16, 18, 26, 28) in der zur Hauptfläche des Substrats (11, 22) senkrechten Richtung.

**Revendications**

1. Dispositif à semiconducteurs comportant un substrat semiconducteur (11, 22) et au moins une électrode (16, 18, 26, 28) fixée sur la surface principale du substrat; l'électrode (16, 18, 26, 28) étant un corps composite comportant des dibres noyées dans un matrice de métal et qui sont disposées essentiellement parallèlement à la surface principale du substrat (11, 22) de telle manière que le coefficient de dilatation thermique de l'électrode (16, 18, 26, 28) suivant des directions parallèles à ladite surface principale du substrat (11, 22) est égal ou approximativement égal à celui du substrat (11, 22), caractérisé en ce qu'un corps en un matériau formé d'une résine synthétique recouvre des parties des surfaces latérales du substrat et de l'électrode de manière à limiter le déplacement latéral relatif de l'électrode et du substrat par application d'une force de serrage, et que le coefficient de dilatation thermique de l'électrode (16, 18, 26, 28) suivant la direction perpendiculaire à ladite surface principale du substrat (11, 22) est égal ou approximativement égal à celui du matériau formé par la résine synthétique (33, 43) de sorte que la force de serrage n'est pas affectée par la dilatation thermique.

2. Dispositif selon la revendication 1, dans lequel au moins au niveau d'une région d'une surface de ladite électrode (laquelle région de la surface est fixée au substrat), les fibres sont disposées selon une configuration annulaire se composant de plusieurs anneaux concentriques ou selon une configuration en spirale avec plusieurs spirales ayant un centre commun.

3. Dispositif selon l'une des revendications 1 ou 2, dans lequel les fibres sont des fibres de carbone et la matrice de métal est du cuivre, le pourcentage en volume des fibres de carbone se situant dans la gamme entre 35 et 55% et le pourcentage en volume du cuivre se situant dans la gamme entre 45 et 55%.

4. Dispositif selon l'une quelconque des revendications précédentes, dans lequel ledit coefficient de dilatation thermique suivant des directions parallèles à ladite surface principale se situe dans la gamme entre $3,5 . 10^{-6}/°C$ et $5 . 10^{-6}/°C$ et que le coefficient de dilatation thermique suivant la direction perpendiculaire à ladite surface principale est compris dans la gamme se situant entre $15 . 10^{-6}/°C$ et $30 . 10^{-6}/°C$.

5. Dispositif selon l'une quelconque des revendications précédentes dans lequel ledit métal est du cuivre.

6. Dispositif selon l'une quelconque des revendications précédentes, dans lequel le substrat comporte une rainure, du verre fritté dans la rainure et du caoutchouc au silicone disposé sur le verre.

7. Dispositif selon l'une quelconque des revendications précédentes, dans lequel les fibres sont formées par du carbone plaqué de cuivre et sont disposées de manière à fournir des caractéristiques de dilatation thermique anisotrope 1.

8. Procédé de fabrication d'un dispositif à semiconducteurs selon la revendication 1, incluant les phases opérations de

a) formant d'une pellicule métallique (17, 19) sur au moins une surface d'une électrode sous la forme d'un corps composite comportant des fibres noyées dans une matrice de métal,

b) puis fixation de ladite électrode au moyen de soudures sur la surface principale du substrat semiconducteur (11, 22), caractérisé en ce que les parties des surfaces latérales dudit substrat et de ladite électrode sont recouvertes par une résine synthétique (33, 43) dans une coque, le coefficient de dilatation thermique de la résine synthétique (33, 43) étant égal ou approximativement égal au coefficient de dilatation thermique de l'électrode (16, 18, 26, 28) suivant la direction perpendiculaire à la surface principale du substrat (11, 22).

# F I G. 1

# F I G. 2

# F I G. 3

# F I G. 4

# F I G. 5